(19) Europäisches Patentamt

European Patent Office

Office européen des brevets

(11) EP 0 504 470 B1

(12) **EUROPÄISCHE PATENTSCHRIFT**

(45) Veröffentlichungstag und Bekanntmachung des Hinweises auf die Patenterteilung:
**28.02.1996 Patentblatt 1996/09**

(51) Int Cl.$^6$: **H03K 3/356**

(21) Anmeldenummer: **91104578.9**

(22) Anmeldetag: **22.03.1991**

(54) **Pegelumsetzschaltung**

Level converting circuit

Circuit translateurs de niveau

(84) Benannte Vertragsstaaten:
**AT DE FR GB IT NL**

(43) Veröffentlichungstag der Anmeldung:
**23.09.1992 Patentblatt 1992/39**

(73) Patentinhaber:
**SIEMENS AKTIENGESELLSCHAFT**
**D-80333 München (DE)**

(72) Erfinder: **Harter, Johann, Dr.**
**Shelburne, Vermont 05482 (US)**

(56) Entgegenhaltungen:
**DE-A- 3 733 046          GB-A- 2 201 059**
**US-A- 4 920 284          US-A- 4 996 443**

- **ELECTRONIC DESIGN. Bd. 33, Nr. 21, 5. September 1985, HASBROUCK HEIGHTS, NEW JERSEY US, Seiten 149 - 154; SHACKLE: 'Standard cells step in to ease the design of high-voltage chips'**
- **MOTOROLA TECHNICAL DEVELOPMENTS. Bd. 7, Oktober 1987, SCHAUMBURG, ILLINOIS US Seite 84; CLEMENT: 'Process-tolerant high level shifter'**

**Beschreibung**

Die Erfindung betrifft eine monolithisch integrierte Pegelumsetzschaltung.

In der modernen Mikroelektronik gibt es verschiedene Halbleitertechnologien, die chip-intern mit unterschiedlichen Versorgungsspannungen und Signalpegeln arbeiten. Diese sind "on chip" mittels Pegelumsetzschaltungen erzeugbar.

Aus der DE-A 37 29 925 ist eine monolithisch integrierte Pegelumsetzschaltung in CMOS-Technik bekannt. Ist diese mit kleinen Strukturen (bis etwa 1 /um) hergestellt, so tritt bei n-Kanal-Transistoren, an denen Potentialdifferenzen von größer als 6 bis 10V auftreten, das bekannte Problem heißer Ladungsträger auf ("heiße Elektronen"; siehe auch H. Terletzki, L. Risch: "Operating Conditions of Dual Gate Inverters for Hot Carrier Reduction", ESSDERC 86, Seiten 191 ff.). Dies führt in n-Kanal-Transistoren zu unerwünschten Degradationserscheinungen wie z.B. Ansteigen der Einsatzspanung $V_{th}$ und Absinken des Drain-Source-Stromes $I_{ds}$. Entsprechendes gilt für p-Kanal-Transistoren ("heiße Löcher").

Aus der DE-A 37 33 046 ist es bekannt, zur Vermeidung dieser Effekte weitere Transistoren vom jeweils selben Kanaltyp vorzusehen, die gatemäßig mit einem konstanten Potential verbunden sind.

Diese bekannte Pegelumsetzschaltung, die monolithisch integriert ist, verfügt über folgende Merkmale:

* Transistoren eines ersten Transistorpärchens von einem ersten Kanaltyp sind sourcemäßig mit einem ersten Potential verbunden,
* an die Gates der Transistoren des ersten Transistorpärchens sind ein Eingangssignal und ein zu diesem komplementäres Eingangssignal anlegbar, deren Pegel das erste Potential und ein zweites Potential aufweisen,
* die Drains der Transistoren des ersten Transistorpärchens sind mit den Sources von Transistoren eines zweiten Transistorpärchens vom selben Kanaltyp verbunden,
* die Gates der Transistoren des zweiten Transistorpärchens sind mit dem zweiten Potential verbunden,
* je ein Transistor zweier weiterer Transistorpärchen vom zweiten Kanaltyp sind mit ihren Kanalstrecken in Serie zueinander geschaltet,
* jeder Transistor des einen der weiteren Transistorpärchen ist an seiner Drain mit der Drain eines der Transistoren des zweiten Transistorpärchens verbunden,
* die Gates der Transistoren des einen der weiteren Transistorpärchen sind mit dem zweiten Potential verbunden.

Heutzutage ist es auch üblich, als Dielektrika für die Gates von MOS-Transistoren solche mit möglichst geringer Dicke zu verwenden, beispielsweise mit einer Dicke von 25 nm und weniger. Im Betrieb entstehen dabei hohe elektrische Feldstärken zwischen Gate und Kanalbereich. Dies kann zu unerwünschten Durchbrüchen des Gatedielektrikums und somit zur Zerstörung des betroffenen Transistors führen.

Aufgabe der vorliegenden Erfindung ist es, eine monolithisch integrierte Pegelumsetzschaltung zu schaffen, die unempfindlich gegen solchen elektrischen Streß ist, d.h., bei der auch bei Anwenden von relativ hohen Spannungen das Auftreten heißer Elektronen und heißer Löcher sowie die Gefahr eines Gatedurchbruchs weitgehend gebannt ist.

Diese Aufgabe wird bei einer gattungsgemäßen Pegelumsetzschaltung durch die Merkmale des Patentanspruches 1 gelöst. Vorteilhafte Aus- und Weiterbildungen sind in abhängigen Ansprüchen gekennzeichnet.

Die Erfindung wird nachstehend anhand von Figuren näher erläutert. Es zeigen:

Die Figuren 1 und 3:  Vorteilhafte Ausführungsformen der Erfindung,
Figur 2:  Eine Darstellung von Ein- und Ausgangssignalen.

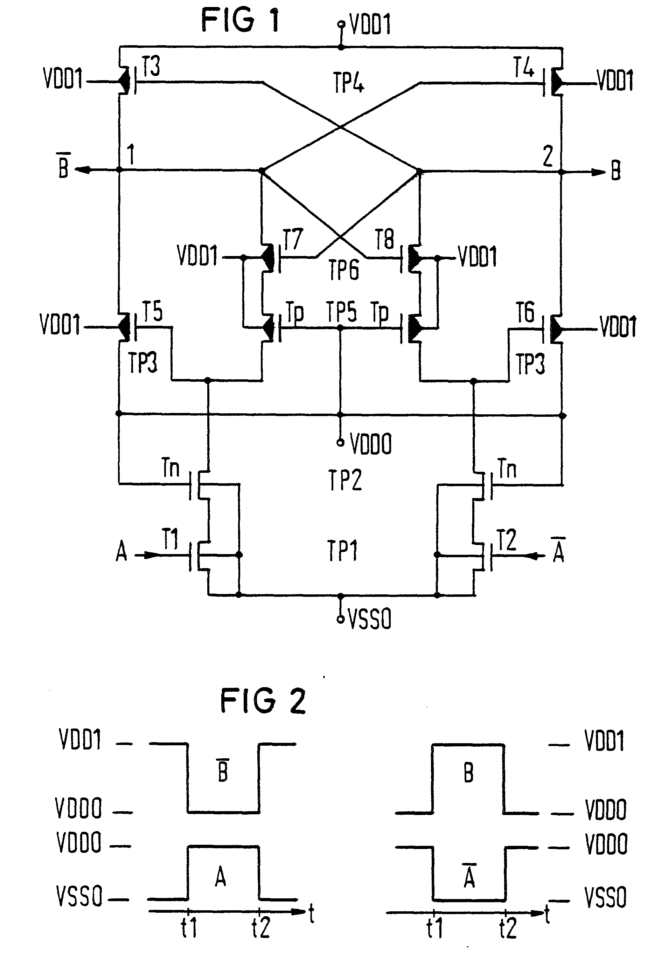

Die Ausführungsform einer erfindungsgemäßen Pegelumsetzschaltung nach Figur 1 enthält ein erstes Transistorpärchen TP1 mit Transistoren T1,T2 vom n-Kanal-Typ, deren Sources mit einem ersten Potential VSS0 verbunden sind. An das Gate des einen Transistors T1 ist im Betrieb ein Eingangssignal A anlegbar, dessen einer Signalpegel, beispielsweise der Low-Pegel, das erste Potential VSSO aufweist und dessen anderer Signalpegel (beispielsweise der High-Pegel) ein zweites Potential VDDO aufweist. Der Wert des ersten Potentials VSSO kann 0 V betragen (wird dann meist als Masse bezeichnet), der des zweiten Potentials VDDO z.B. 3 V. An das Gate des anderen Transistors T2 ist im Betrieb ein zum Eingangssignal A komplementäres Eingangssignal $\overline{A}$ anlegbar.

Die Pegelumsetzschaltung enthält außerdem ein zweites Transistorpärchen TP2 mit Transistoren Tn, ebenfalls vom n-Kanal-Typ. Die Drains der Transistoren T1,T2 des ersten Transistorpärchens TP1 sind jeweils mit der Source des zugehörigen Transistors Tn des zweiten Transistorpärchens TP2 verbunden. Die Gates der Transistoren Tn des zweiten Transistorpärchens TP2 sind mit dem zweiten Potential VDD0 verbunden.

Weiterhin enthält die Schaltung ein drittes Transistorpärchen TP3 mit Transistoren T5 ,T6 und ein viertes Transistorpärchen TP4 mit Transistoren T3, T4. Diese Transistoren (T3 bis T6) sind vom p-Kanal-Typ. Die Transistoren T5 und T3 des dritten und des vierten Transistorpärchens TP3,TP4 sind mit ihren Kanalstrecken in Serie zueinander geschaltet. Entsprechend sind die Transistoren T6 und T4 des dritten und des vierten Transistorpärchens TP3,TP4 mit ihren Kanalstrecken ebenfalls in Serie zueinander geschaltet. Dabei entstehen an den Drains der Transistoren T3,T4 des vierten Transistorpärchens TP4 (entsprechend den Sources der Transistoren T5,T6 des dritten Transistorpärchens TP3) ein erster und ein zweiter Schaltungsknoten 1,2 für Ausgangssignale $\bar{B}$,B der Pegelumsetzschaltung. Die Ausgangssignale B,$\bar{B}$ sind zueinander komplementär. Das Gate des einen Transistors T3 des vierten Transistorpärchens TP4 ist mit der Drain des anderen Transistors T4 des vierten Transistorpärchens TP4 verbunden. Entsprechend ist auch das Gate des anderen Transistors T4 des vierten Transistorpärchens TP4 mit der Drain des einen Transistors T3 des vierten Transistorpärchens TP4 verbunden. Gates und Drains der Transistoren T3,T4 des vierten Transistorpärchens TP4 sind also kreuzweise miteinander verbunden und somit auch mit jeweils einem der beiden Schaltungsknoten 2,1 sowie mit der Source jeweils eines der Transistoren T6,T5 des dritten Transistorpärchens TP3. Die Sources der Transistoren T3,T4 des vierten Transistorpärchens TP4 sind mit einem dritten Potential VDD1 verbunden. Die Drains der Transistoren T5,T6 des dritten Transistorpärchens TP3 sind mit dem zweiten Potential VDD0 verbunden und somit auch mit den Gates der Transistoren In des zweiten Transistorpärchens TP2.

Darüber hinaus enthält die Pegelumsetzschaltung ein fünftes (TP5) und ein sechstes Transistorpärchen TP6 mit zwei Transistoren Tp (TP5) bzw. Transistoren T7,T8 (TP6). Jeweils ein Transistor Tp des fünften Transistorpärchens TP5 und ein Transistor T7 bzw. T8 des sechsten Transistorpärchens TP6 sind mit ihren Kanalstrecken in Serie zueinander geschaltet. Je einer der Transistoren Tp des fünften Transistorpärchens TP5 ist an seiner Drain mit dem Gate eines (T5 bzw. T6) der beiden Transistoren T5,T6 des dritten Transistorpärchens TP3 und somit auch mit der Drain jeweils eines der Transistoren Tn des zweiten Transistorpärchens TP2 verbunden. Die Gates der beiden Transistoren Tp des fünften Transistorpärchens TP5 sind mit dem zweiten Potential VDD0 verbunden. Das Gate des einen Transistors T7 des sechsten Transistorpärchens TP6 ist mit dem zweiten Schaltungsknoten 2 verbunden und somit auch mit dem Gate des Transistors T3 des vierten Transistorpärchens TP4. Es ist weiterhin mit der Source des anderen Transistors T8 des sechsten Transistorpärchens TP6 verbunden. Entsprechend ist das Gate des anderen Transistors T8 des sechsten Transistorpärchens TP6 mit dem ersten Schaltungsknoten 1 verbunden und somit auch mit dem Gate des Transistors T4 des vierten Transistorpärchens TP4. Es ist ebenfalls mit der Source des einen Transistors T7 des sechsten Transistorpärchens TP6 verbunden. Gates und Sources der Transistoren T7,T8 des sechsten Transistorpärchens TP6 sind also jeweils kreuzweise miteinander verbunden.

In der Ausführungsform nach Figur 1 sind die Transistoren T1, T2,Tn der ersten beiden Transistorpärchen TP1,TP2 vom n-Kanal-Typ. Entsprechend sind die Transistoren T3 bis T8 und Tp der dritten bis sechsten Transistorpärchen TP3 bis TP6 vom p-Kanal-Typ. Dabei ist es vorteilhaft, wenn das zweite Potential VDD0 positiver als das erste Potential VSS0 ist und negativer als das dritte Potential VDD1.

Nachstehend wird nun die Funktion der in Figur 1 dargestellten Ausführungsform der Pegelumsetzschaltung auch anhand des in Figur 2 dargestellten Signalverlaufes bezüglich der Eingangssignale A,$\bar{A}$ und der Ausgangssignale B,$\bar{B}$ erläutert. Dabei werden beispielhaft folgende Werte für die drei Potentiale VSS0,VDD0 und VDD1 angenommen: Erstes Potential VSS0 = 0 V, zweites Potential VDD0 = 3 V, drittes Potential VDD1 = 8 V.

Bis zu einem ersten Zeitpunkt t1 weisen das eine Eingangssignal A einen Low-Wert von erstes Potential VSS0 = 0 Volt auf und entsprechend das andere Eingangssignal $\bar{A}$ einen High-Wert von zweites Potential VDD0 = 3 V. Der Transistor T1 des ersten Transistorpärchens TP1 ist gesperrt. Folgende Transistoren der Pegelumsetzschaltung sind durchgeschaltet: Transistor T2 des ersten Transistorpärchens TP1, der mit diesem verbundene Transistor Tn des zweiten Transistorpärchens TP2 und Transistor T6 des dritten Transistorpärchens TP3. Wegen der Verbindung des Transistors T6 des dritten Transistorpärchens TP3 mit dem zweiten Potential VDD0 = 3 V nimmt der zweite Schaltungsknoten 2 einen Wert von zweites Potential VDD0 = 3 V an. Dies entspricht dem Low-Pegel des einen Ausgangssignales B. Damit wiederum wird der dritte Transistor T3 des vierten Transistorpärchens TP4 durchgeschaltet, der erste Schaltungsknoten 1, und somit auch das andere Ausgangssignal $\bar{B}$, das zum einen Ausgangssignal B komplementär ist, nehmen den Wert des dritten Potentials VDD1 = 8 V an, was dem High-Pegel des anderen Ausgangssignales $\bar{B}$ entspricht.

Infolgedessen sind folgende Transistoren gesperrt: Der Transistor T4 des vierten Transistorpärchens TP4, Transistor T8 des sechsten Transistorpärchens TP6, der mit diesem verbundene Transistor Tp des fünften Transistorpärchens TP5. Andererseits ist der Transistor T7 des sechsten Transistorpärchens TP6 leitend, und somit auch der mit diesem verbundene Transistor Tp des fünften Transistorpärchens TP5. Deshalb liegt am Gate des Transistors T5 des dritten Transistorpärchens TP3 das dritte Potential VDD1 = 8 V an, wodurch dieser Transistor (T5) sperrt.

Zwischen dem ersten Zeitpunkt t1 und einem zweiten Zeitpunkt t2 weist das eine Eingangssignal A einen High-Pegel von zweites Potential VDDO = 3 V auf. Entsprechend weist das andere, zum einen Eingangssignal A komplementäre Eingangssignal $\bar{A}$ einen Low-Pegel von erstes Potential VSS0 = 0 V auf. Dieser Zustand ist genau umgekehrt zum bereits beschriebenen Zustand bis zum ersten Zeitpunkt t1. Aus diesem Grunde nehmen bei jedem der sechs Transistorpärchend TP1 bis TP6 die einen Transistoren T1, Tn (mit dem Transistor T1 verbunden), T5,T3, (der mit dem Transistor T7 verbundene Transistor) Tp und T7 den Zustand an, den bis zum ersten Zeitpunkt t1 die jeweils anderen Transistoren T2,Tn (mit diesem verbunden), T6,T4, (der mit dem Transistor T8 verbundene Transistor) Tp und T8 aufwiesen und umgekehrt (wegen der vorliegenden Schaltungs- und Signalsymmetrie erübrigt sich für den Fachmann eine detailliertere Erläuterung). Das eine Ausgangssignal B weist somit als High-Pegel den Wert des dritten Potentials VDD1 = 8 V auf, während das andere, zum einen Ausgangssignal B komplementäre Ausgangssignal $\overline{B}$ als Low-Pegel den Wert des zweiten Potentials VDD0 = 3 V aufweist.

Ab dem zweiten Zeitpunkt t2 liegen dann wieder dieselben Schaltungs- und Signalzustände vor wie im bereits beschriebenen Zeitraum bis zum ersten Zeitpunkt t1.

Insgesamt betrachtet, weisen also die Eingangssignale A,$\overline{A}$ Signalpegel mit den Werten des ersten (VSSO) und des zweiten Potentials VDD0 auf und die Ausgangssignale B,$\overline{B}$ Signalpegel mit den Werten des zweiten (VDD0) und des dritten Potentials VDD1.

Das Auftreten heißer Elektronen bzw. Löcher wird bei der vorliegenden Erfindung also dadurch vermieden, daß sämtliche Schaltungsabschnitte, über die die maximal auftretende Spannung (drittes Potential VDD1 - erstes Potential VSSO) geschaltet wird, zwei Transistoren vom jeweils selben Leitungstyp enthalten: Transistor T7 und mit diesem verbundener Transistor Tp bzw. Transistor T8 und mit diesem verbundener Transistor Tp sowie Transistor T1 und mit diesem verbundener Transistor Tn bzw. Transistor T2 und mit diesem verbundener Transistor Tn.

Die Gefahr eines Gatedielektrikum-Durchbruchs wird bei der vorliegenden Erfindung dadurch vermieden, daß an keinem Gatedielektrikum eine größere Spannung anliegt als (drittes Potential VDD1 - zweites Potential VDD0) bzw. (zweites Potential VDD0 - erstes Potential VSS0).

Die erfindungsgemäße Pegelumsetzschaltung ist also geschützt gegen heiße Elektronen, heiße Löcher und gegen Durchbrüche von Gatedielektrika.

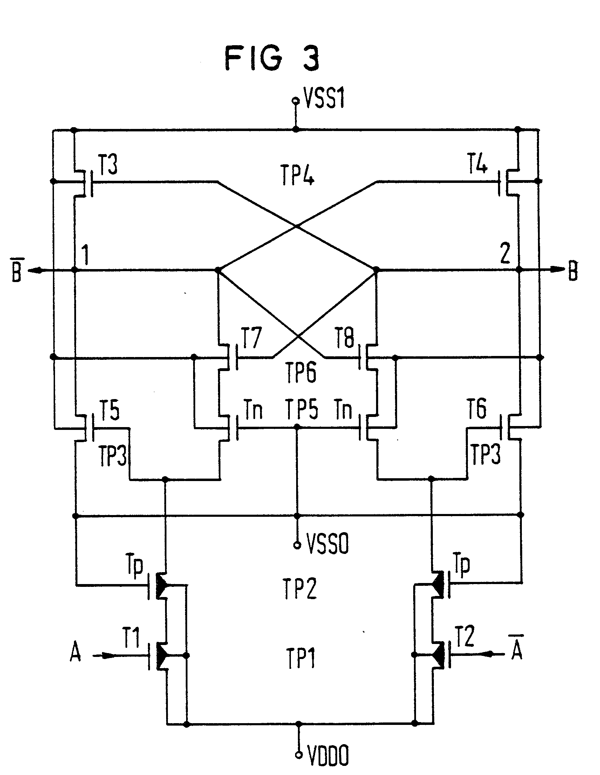

Figur 3 zeigt eine Ausführungsform der Erfindung, bei der die Transistoren T1,T2 des ersten Transistorpärchens TP1 und die Transistoren des zweiten Transistorpärchens TP2 als Transistoren Tp vom p-Kanal-Typ sind, während die Transistoren T3 bis T8 des dritten, vierten und sechsten Transistorpärchens TP3, TP4, TP6 sowie die Transistoren des fünften Transistorpärchens TP5 als Transistoren Tn vom n-Kanal-Typ sind. Der Wert des zweiten Potentials, hier mit VSS0 bezeichnet, ist negativer als der des ersten Potentials, hier mit VDD0 bezeichnet und positiver als der des dritten Potentials, hier mit VSS1 bezeichnet. Mit der Ausführungsform nach Figur 3 lassen sich Eingangssignale A,$\overline{A}$ mit Pegelwerten von beispielsweise zweites Potential VSS0 = 0 V und erstes Potential VDD0 = 3 V umsetzen in Ausgangssignale B,$\overline{B}$ mit Pegelwerten von beispielsweise drittes Potential VSS1 = -5 V und zweites Potential VSS0 = 0 V.

Zur Vermeidung des Auftretens von Latch-up-Effekten ist es, unabhängig von der jeweiligen Ausführungsform der Erfindung, vorteilhaft, die Substratbereiche derjenigen Transistoren, die vom p-Kanal-Typ sind (Figur 1: Transistoren T3 bis T8 und Tp; Figur 3: Transistoren T1,T2,Tp) mit dem positivsten der drei Potentiale VSS0,VDD0,VDD1 bzw. VDD0,VSS0,VSS1 zu verbinden oder mit einem noch positiveren Potential. Entsprechendes gilt für die Substratbereiche der n-Kanal-Transistoren (Figur 1: Transistoren T1, T2, Tn; Figur 3: Transistoren T3 bis T8 und Tn): Diese sind vorteilhafterweise mit dem negativsten der drei Potentiale VSS0, VDD0, VDD1 bzw. VDD0, VSS0, VSS1 zu verbinden oder mit einem noch negativeren Potential.

Im Falle der Ausführungsform nach Figur 1 sind dies das dritte Potential VDD1 und das erste Potential VSS0. Im Falle der Ausführungsform nach Figur 3 sind dies das erste Potential VDD0 und das dritte Potential VSS1.

Die erfindungsgemäße Pegelumsetzschaltung liefert im Betrieb Ausgangssignale B,$\overline{B}$ mit Pegelwerten, die dem Unterschied zwischen dem Wert des zweiten Potentials VDD0 bzw. VSS0 und dem Wert des dritten Potentials VDD1 bzw. VSS1 entsprechen. Betreibt man nun eine der Pegelumsetzschaltung nachgeschaltete andere Schaltung, z.B. eine Wortleitungs-Treiberschaltung in einem DRAM, die ja im allgemeinen einen gegenüber sonstigen Schaltungsteilen des DRAM's überhöhten High-Pegel schalten soll, mit der erfindungsgemäßen Pegelumsetzschaltung, so liegen die Low-Pegel ihrer Ausgangssignale B,$\overline{B}$ (positive Logik angenommen) höher als der übliche Low-Pegel der anderen Schaltung (hier angenommen: Wortleitungs-Treiberschaltung). Dies ist jedoch dann nicht störend, wenn man dies beim Schaltverhalten der Eingangsstufe dieser anderen Schaltung berücksichtigt, d.h. wenn man die Eingangsstufe so dimensioniert, daß ihr Low-Pegel-Pfad auch dann gesperrt ist, wenn an ihr eines der Ausgangssignale B,$\overline{B}$ der Pegelumsetzschaltung mit dessen Low-Pegel anliegt. Eine solche Berücksichtigung ist jedoch lediglich eine einfache Dimensionierungsmaßnahme, d.h. sie liegt im Bereich des Könnens jedes zuständigen Durchschnittsfachmanns.

Damit läßt sich die erfindungsgemäße Pegelumsetzschaltung auch bei DRAM's, insbesondere in deren Wortleitungs-Schaltungen einsetzen.

Die Erfindung ist auch anwendbar auf Eingangssignale A,$\overline{A}$, die keine zeitabhängige Änderung ihrer Pegel aufweisen, sondern stattdessen Pegel aufweisen, die ein konstantes Potential sind. Die Funktion der erfindungsgemäßen Pegelumsetzschaltung ist dann eine reine Potentialverschiebung.

**Patentansprüche**

1.  Pegelumsetzschaltung, die monolithisch integriert ist, mit folgenden Merkmalen :

    -   Transistoren (T1,T2) eines ersten Transistorpärchens (TP1) von einem ersten Kanaltyp sind sourcemäßig mit einem ersten Potential (VSS0;VDD0) verbunden,

- an die Gates der Transistoren (T1,T2) des ersten Transistorpärchens (TP1) sind ein Eingangssignal (A) und ein zu diesem komplementäres Eingangssignal ($\overline{A}$) anlegbar, deren Pegel das erste Potential (VSS0;VDD0) und ein zweites Potential (VDD0; VSS0) aufweisen,
- die Drains der Transistoren (T1,T2) des ersten Transistorpärchens (TP1) sind mit den Sources von Transistoren (Tn; Tp) eines zweiten Transistorpärchens (TP2) vom selben Kanaltyp verbunden,
- die Gates der Transistoren (Tn;Tp) des zweiten Transistorpärchens (TP2) sind mit dem zweiten Potential (VDDO;VSSO) verbunden,
- je ein Transistor (T5,T3;T6,T4) eines dritten und eines vierten Transistorpärchens (TP3,TP4) von einem zweiten Kanaltyp sind mit ihren Kanalstrecken in Serie zueinander geschaltet, wobei an den Drains der Transistoren (T3,T4) des vierten Transistorpärchens (TP4) ein erster und ein zweiter Schaltungsknoten (1,2) entstehen für Ausgangssignale ($\overline{B}$,B) der Pegelumsetzschaltung,
- das Gate jedes der Transistoren (T3,T4) des vierten Transistorpärchens (TP4) ist kreuzweise mit der Drain des jeweils anderen (T4,T3) dieser Transistoren verbunden,
- die Sources der Transistoren (T3,T4) des vierten Transistorpärchens (TP4) sind mit einem dritten Potential (VDDI;VSSI) verbunden,
- die Drains der Transistoren (T5,T6) des dritten Transistorpärchens (TP3) sind mit dem zweiten Potential (VDDO;VSSO) verbunden,
- je ein Transistor (Tp,T7;Tp,T8 bzw. Tn,T7;Tn,T8) eines fünften und eines sechsten Transistorpärchens (TP5,TP6) vom zweiten Kanaltyp sind mit ihren Kanalstrecken in Serie zueinander geschaltet,
- jeder Transistor (Tp;Tn) des fünften Transistorpärchens (TP5) ist an seiner Drain mit dem Gate eines (T5;T6) der Transistoren des dritten Transistorpärchens (TP3) sowie mit der Drain eines (Tn ; Tp) der Transistoren des zweiten Transistorpärchens (TP2) verbunden,
- die Gates der Transistoren (Tp;Tn) des fünften Transistorpärchens (TP5) sind mit dem zweiten Potential (VDD0;VSS0) verbunden,
- das Gate jedes der Transistoren (T7;T8) des sechsten Transistorpärchens (TP6) ist kreuzweise mit der Source des jeweils anderen (T8;T7) dieser Transistoren und mit einem (2; 1) der beiden Schaltungsknoten (1, 2) verbunden.

2. Pegelumsetzschaltung nach Anspruch 1, **dadurch gekennzeichnet,** daß die Transistoren des ersten Kanaltyps (T1,T2,Tn) vom n-Kanal-Typ sind und daß die Transistoren des zweiten Kanaltyps (T3,T4,T5,T6,T7,T8,Tp) vom p-Kanal-Typ sind.

3. Pegelumsetzschaltung nach Anspruch 1 oder 2, **dadurch gekennzeichnet,** daß das zweite Potential (VDD0) positiver ist als das erste Potential (VSS0) und negativer als das dritte Potential (VDD1).

4. Pegelumsetzschaltung nach Anspruch 1, **dadurch gekennzeichnet,** daß die Transistoren des ersten Kanaltyps (T1,T2,Tp) vom p-Kanal-Typ sind und daß die Transistoren des zweiten Kanaltyps (T3,T4,T5,T6,T7,T8,Tn) vom n-Kanal-Typ sind.

5. Pegelumsetzschaltung nach Anspruch 1 oder 4, **dadurch gekennzeichnet,** daß das zweite Potential (VSS0) negativer ist als das erste Potential (VDD0) und positiver als das dritte Potential (VSS1).

6. Pegelumsetzschaltung nach einem der vorhergehenden Ansprüche, **dadurch gekennzeichnet,** daß diejenigen Transistoren (T3 bis T8,Tp;T1,T2,Tp), die vom p-KanalTyp sind, in ihrem Substratbereich mit dem positivsten (VDD1; VDD0) der drei Potentiale (VSS0,VDD0,VDD1;VDD0,VSS0,VSS1) verbunden sind oder mit einem noch positiveren Potential.

7. Pegelumsetzschaltung nach einem der vorhergehenden Ansprüche, **dadurch gekennzeichnet,** daß diejenigen Transistoren (T1,T2,Tn;T3 bis T8,Tn), die vom n-Kanallyp sind, in ihrem Substratbereich mit dem negativsten (VSS0;VSS1) der drei Potentiale (VSS0,VDD0,VDD1;VDD0,VSS0,VSS1) verbunden sind oder mit einem noch negativeren Potential.

8. Pegelumsetzschaltung nach einem der vorhergehenden Ansprüche, **dadurch gekennzeichnet,** daß als Eingangssignale (A,$\overline{A}$) Signale mit konstanten Potentialwerten dienen, die gleich sind dem ersten Potential (VSS0;VDD0) und dem zweiten Potential (VDD0;VSS0).

**Claims**

1. Level converting circuit which is monolithically integrated, having the following features:

   - the sources of transistors (T1, T2) of a first transistor pair (TP1) of a first channel type are connected to a first potential (VSS0; VDD0),

   - an input signal (A) and an input signal ($\overline{A}$) which is complementary thereto can be applied to the gates of the transistors (T1, T2) of the first transistor pair (TP1), the levels of which input signals have the first potential (VSS0; VDD0) and a second potential (VDD0; VSS0),

   - the drains of the transistors (T1, T2) of the first transistor pair (TP1) are connected to the sources of transistors (Tn; Tp) of a second transistor pair (TP2) of the same channel type,

   - the gates of the transistors (Tn; Tp) of the second transistor pair (TP2) are connected to the second potential (VDD0; VSS0),

   - the channel paths of one transistor (T5, T3; T6, T4) each of a third and of a fourth transistor pair (TP3, TP4) of a second channel type are connected in series with one another, a first and a second circuit node (1, 2) being produced, at the drains of the transistors (T3, T4) of the fourth transistor pair (TP4), for output signals ($\overline{B}$, B) of the level converting circuit,

   - the gate of each of the transistors (T3, T4) of the fourth transistor pair (TP4) is connected in a cross to the drain of the respective other (T4, T3) of these transistors,

   - the sources of the transistors (T3, T4) of the fourth transistor pair (TP4) are connected to a third potential (VDD1; VSS1),

   - the drains of the transistors (T5, T6) of the third transistor pair (TP3) are connected to the second potential (VDD0; VSS0),

   - the channel paths of one transistor (Tp, T7; Tp, T8 and Tn, T7; Tn, T8, respectively) each of a fifth and of a sixth transistor pair (TP5, TP6) of the second channel type are connected in series with one another,

   - each transistor (Tp; Tn) of the fifth transistor pair (TP5) is connected at its drain to the gate of one (T5; T6) of the transistors of the third transistor pair (TP3) as well as to the drain of one (Tn; Tp) of the transistors of the second transistor pair (TP2),

   - the gates of the transistors (Tp; Tn) of the fifth transistor pair (TP5) are connected to the second potential (VDD0; VSS0),

   - the gate of each of the transistors (T7; T8) of the sixth transistor pair (TP6) is connected in a cross to the source of the respective other (T8; T7) of these transistors and to one (2; 1) of the two circuit nodes (1, 2).

2. Level converting circuit according to Claim 1, characterized in that the transistors of the first channel type (T1, T2, Tn) are of the n-channel type, and in that the transistors of the second channel type (T3, T4, T5, T6, T7, T8, Tp) are of the p-channel type.

3. Level converting circuit according to Claim 1 or 2, characterized in that the second potential (VDD0) is more positive than the first potential (VSS0) and more-negative than the third potential (VDD1).

4. Level converting circuit according to Claim 1, characterized in that the transistors of the first channel type (T1, T2, Tp) are of the p-channel type, and in that the transistors of the second channel type (T3, T4, T5, T6, T7, T8, Tn) are of the n-channel type.

5. Level converting circuit according to Claim 1 or 4, characterized in that the second potential (VSS0) is more negative than the first potential (VDD0) and more positive than the third potential (VSS1).

6. Level converting circuit according to one of the preceding claims, characterized in that those transistors (T3 to T8, Tp; T1, T2, Tp) which are of the p-channel type are connected in their substrate region to the most positive (VDD1; VDD0) of the three potentials (VSS0, VDD0, VDD1; VDD0, VSS0, VSS1) or to an even more positive potential.

7. Level converting circuit according to one of the preceding claims, characterized in that those transistors (T1, T2, Tn; T3 to T8, Tn) which are of the n-channel type are connected in their substrate region to the most negative (VSS0; VSS1) of the three potentials (VSS0, VDD0, VDD1; VDD0, VSS0, VSS1) or to an even more negative potential.

8. Level converting circuit according to one of the preceding claims, characterized in that signals having constant potential values which are equal to the first potential (VSS0; VDD0) and to the second potential (VDD0; VSS0) are used as the input signals (A, $\overline{A}$ ).

**Revendications**

1.  Circuit convertisseur de niveau, qui est intégré monolithiquement et qui a les particularités suivantes :

    -   des transistors (T1, T2) d'un premier couple (TP1) de transistors ayant un canal d'un premier type sont reliés par leur source à un premier potentiel (VSS0 ; VDD0),
    -   un signal (A) d'entrée et un signal ($\overline{A}$) complémentaire au signal d'entrée (A), dont les niveaux ont le premier potentiel (VSS0 ; VDD0) et un second potentiel (VDD0 ; VSSO), peuvent être appliqués aux grilles des transistors (T1, T2) du premier couple (TP1) de transistors,
    -   les drains des transistors (T1, T2) du premier couple (TP1) de transistors sont reliés aux sources des transistors (Tn ; Tp) d'un second couple (TP2) de transistors de même type de canaux,
    -   les grilles des transistors (Tn ; Tp) du second couple (TP2) de transistors sont reliées au second potentiel (VDD0 ; VSS0),
    -   chaque transistor (T5, T3 ; T6, T4) de troisième et quatrième couples (TP3, TP4) de transistors ayant des canaux d'un second type sont branchés par leurs voies de canal en série les uns avec les autres, des premier et second noeuds (1, 2) de circuit apparaissant aux drains des transistors (T3, T4) du quatrième couple (TP4) de transistors pour des signaux ($\overline{B}$, B) de sortie du circuit convertisseur de niveau,
    -   la grille de chacun des transistor (T3, T4) du quatrième couple (TP4) de transistors est reliée en croix au drain de l'autre transistor (T4, T3) de ces transistors,
    -   les sources des transistors (T3, T4) du quatrième couple (TP4) de transistors sont reliées à un troisième potentiel (VDD1 ; VSS1),
    -   les drains des transistors (T5, T6) du troisième couple (TP3) de transistors sont reliés à un second potentiel (VDD0 ; VSS0),
    -   chaque transistor (Tp, T7 ; Tp, T8 ou Tn, T7 ; Tn, T8) de cinquième et sixième couples (TP5, TP6) de transistors ayant des canaux du second type sont branchés par leurs voies de canal en série les uns avec les autres,
    -   chaque transistor (TP ; Tn) du cinquième couple (TP5) de transistors est relié par son drain la grille d'un (T5 ; T6) des transistors du troisième couple (TP3) de transistors ainsi qu'au drain d'un (Tn ; Tp) des transistors du second couple (TP5) de transistors,
    -   les grilles des transistors (Tp ; Tn) du cinquième couple (TP5) de transistors sont reliées à un second potentiel (VDD0 ; VSS0),
    -   la grille de chacun des transistors (T7 ; T8) du sixième couple (TP6) de transistors est reliée en croix à la source de l'autre transistor (T8 ; T7) de ces transistors et à l'un (2; 1) des deux noeuds (1, 2) de circuit.

2.  Circuit convertisseur de niveau suivant la revendication 1, caractérisé en ce que les transistors ayant un canal du premier type (T1, T2, Tn) ont un canal de type n et les transistors ayant un canal du second type (T3, T4, T5, T6, T7, T8, Tp) ont un canal du type p.

3.  Circuit convertisseur de niveau suivant la revendication 1 ou 2, caractérisé en ce que le second potentiel (VDD0) est plus grand que le premier potentiel (VSS0) et plus petit que le troisième potentiel (VDD1).

4.  Circuit convertisseur de niveau suivant la revendication 1, caractérisé en ce que les transistors ayant un canal du premier type (T1, T2, Tp) ont un canal du type p et les transistors ayant un canal n du second type (T3, T4, T5, T6, T7, T8, Tn) ont un canal du type n.

5.  Circuit convertisseur de niveau suivant la revendication 1 ou 4, caractérisé en ce que le second potentiel (VSS0) est inférieur au premier potentiel (VDD0) et supérieur au troisième potentiel (VSS1).

6.  Circuit convertisseur de niveau suivant l'une des revendications précédentes, caractérisé en ce que la zone de substrat de ceux des transistors (T3 à T8, Tp ; T1, T2, Tp), qui ont un canal du type p sont reliés au plus grand (VDD1 ; VDD0) des trois potentiels (VSS0, VDD0, VDD1 ; VDD0, VSS0, VSS1) ou à un potentiel plus grand encore.

7.  Circuit convertisseur de niveau suivant l'une des revendications précédentes, caractérisé en ce que la zone de substrat de ceux des transistors (T1, T2, Tn ; T3 à T8, Tn) qui ont un canal du type n sont reliés au plus petit (VSS0 ; VSS1) des trois potentiels (VSS0, VDD0, VDD1 ; VDD0, VSS0, VSS1) ou à un potentiel plus petit encore.

8. Circuit convertisseur de niveau suivant l'une des revendications précédentes, caractérisé en ce que des signaux, qui ont des valeurs de potentiel constantes égales au premier potentiel (VSS0 ; VDD0) et au second potentiel (VDD0; VSS0), servent de signaux (A, $\overline{A}$ ) d'entrée.

# FIG 1

# FIG 2

# FIG 3